# EUROPEAN PATENT SPECIFICATION

(11) **EP 1 945 014 B1**
(45) Date of publication and mention of the grant of the patent: **07.03.2012**
(21) Application number: 07000545.9
(22) Date of filing: 11.01.2007
(51) Int. Cl.: H05K 7/20

(54) **Cooling system for an electronic device**
Kühlsystem für eine elektronische Vorrichtung
Système de refroidissement pour dispositif électronique

(43) Date of publication of application: 16.07.2008
(73) Proprietor: Harman Becker Automotive Systems GmbH, 76307 Karlsbad (DE)
(72) Inventor: Maul, Manfred, 75344 Straubenhardt (DE)
(74) Representative: Bertsch, Florian Oliver

(56) References cited:
- WO-A-03/085471
- DE-B3- 10 346 723
- US-B1- 6 341 064

## Description

This invention relates to electronic devices, and especially relates to a cooling of such electronic devices. The invention finds especially application in electronic systems incorporated into a console or dashboard of a passenger compartment of a vehicle.

### Related Art

In recent years the use of electronic devices such as multi-media systems in vehicles is proliferating. In vehicles electronic devices are used for different purposes. A first application may be a navigation application in which the driver is guided from the present location to a predetermined destination. Another application is an audio module allowing the driver to use an audio entertainment system in the vehicle. Furthermore, a radio receiver may be provided for receiving different radio programs. Furthermore, the use of telecommunication modules has become more common in vehicles. For all these different applications a predetermined limited space is available in the dashboard of the vehicle. The processors controlling the different modules generate heat which has to be dissipated. Additionally, the packing density behind the dashboard generally increases, as more and more components of the vehicle are installed behind the dashboard. Furthermore, more and more material is used in the space behind the dashboard in order to increase the noise reduction properties, resulting in a further decreased space for the components to be installed. In view of the space constraints a need exists to further minimize the space in the vehicle provided for the different applications. As a consequence the packing density of the different heat generating electronic modules increases. In this context an effective cooling system has to be provided removing the generated heat from the electronic device. Conventionally, cooling air is used, the cooling air moving in the electronic device removing the generated heat.

Also in non-vehicle applications the cooling of electronic devices is a challenge which has to be met. In these non-vehicle applications, it may be necessary for design reasons to provide a compact and small electronic device having a high packing density so that also in non-vehicle applications the cooling of these devices is a challenging task.

WO 03/085471 discloses an electronic device with a heat dissipating structure as disclosed in the preamble of claim 1.

In all the different applications a need exists to provide an effective cooling of electronic devices comprising heat generating units.

### Summary of the Invention

This need is met by the features of the independent claim. In the dependent claims preferred embodiments of the invention are described.

According to a first aspect of the invention an electronic device is provided comprising at least one first heat generating unit. This at least one first heat generating unit is installed in a housing surrounding the heat generating unit. In order to cool the electronic device an airflow guiding structure is present adapted to guide cooling air through the housing for removing the generated heat. A first heat dissipating structure is provided coupled to said at least one first heat generating unit for dissipating the generated heat. According to an important aspect of the invention the airflow guiding structure is at least partly built by said first heat dissipating structure. In the electronic device of the invention the heat generating unit is coupled to the heat dissipating structure having a high thermal conductivity. Due to the fact that the first heat dissipating structure partly builds the airflow guiding structure, the air moving along the heat dissipating structure cools the heat dissipating structure in an effective way. First of all, the airflow in the electronic device and in the housing is guided along a predetermined way through the housing by the airflow guiding structure which is at the same time the heat dissipating structure. These aspects help to provide an electronic device in which an effective cooling mechanism can be obtained, as the cooling air is guided to the locations where most of the heat is generated. Furthermore, by providing the airflow guiding structure it can be avoided that the cooling air is moved along electronic heat generating components for which the presence of cooling air in their neighborhood should be avoided. By way of example a disk drive should not be placed at a location where a large amount of cooling air is passing, as this cooling air may contain small dust particles which could impede the proper functioning of the disk drive. The airflow guiding structure helps to guide the cooling air to locations where it is mostly needed and helps to avoid the provision of cooling air at unwanted locations.

According to the invention the first heat dissipating structure builds a first side wall of the airflow guiding structure. The sidewall of the airflow channel helps to correctly guide the airflow in the housing. As the heat dissipating structure builds a first sidewall of the airflow guiding structure, the air can also effectively cool the heat dissipating structure by removing the heat from the heat dissipating structure.

Furthermore, a second sidewall is provided building the airflow guiding structure together with the first sidewall. Preferably, the first and the second sidewall build a closed space delimiting the space in which the cooling air can move. This helps to effectively guide the cooling air to the locations where it is needed most and furthermore helps to avoid that the cooling air reaches other areas which it should not reach.

According to the invention the second sidewall is built by a second heat dissipating structure coupled to at least one second heat generating unit. In many electronic devices several heat generating units such as processors are provided. In the context of the present invention the heat generating units are classified as first and second heat generating units. This classification in first and second units is made in order to indicate the different position of the units within the housing. By way of example the first heat generating unit(s) can be provided on a first printed circuit board provided at a first location inside the housing, whereas the second heat generating unit(s) can be provided on a second printed circuit board provided at a different location inside the housing. These different heat generating units, the first heat generating units and the second heat generating units can be effectively cooled when the second heat generating units are also coupled to the second heat dissipating structure which builds the second part of the sidewall of the airflow guiding structure. In this example the airflow guiding structure is built by the first and the second heat dissipating structure. In such an embodiment it is possible to couple all the heat generating units provided in the housing to the two different heat dissipating structures building the sidewalls of the airflow guiding structure. The heat generated by the heat generating units is transferred to the different heat dissipating structures, these structures also delimiting the base for the cooling air. It should be understood that also more than two heat dissipating structures can be provided building the sidewalls of the airflow guiding structure.

The heat generating units can be connected to a wired printed circuit board on one of their main surfaces. The heat generating unit can then be coupled to the heat dissipating structure through the other main surface. In one embodiment the first and second heat dissipating structures substantially extend along the complete width of the housing extending from one side surface of the housing to the other side surface. The heat dissipating structure can then help to maintain the mechanical stability in the housing. In an arrangement where the heat dissipating structure is coupled to the surface opposite to the surface of the heat generating unit at which the latter is connected to a circuit board, the heat dissipating structure will substantially extend in parallel to the circuit board.

In one embodiment of the invention the airflow guiding structure comprises a main airflow channel and supply channels discharging into the main airflow channel. Preferably, openings are provided in any of the surfaces of the housing through which the cooling air is directly supplied to the airflow guiding structure. It is now possible to provide the airflow guiding structure in such a way that the openings are provided in different side surfaces of the housing, preferably in opposite side surfaces of the housing, and the supplied air enters the housing through the openings in the side surfaces, is guided through the supply channels to the main airflow channel and leaves the housing at the end of the main airflow channel. The airflow guiding structure and therefore the heat dissipating structure can be arranged in such a way that the cooling air entering through the openings directly meets the airflow guiding structure in the form of the supply channels. The airflow guiding structure can directly contact the side surfaces in which the inlet openings for the air are provided. In such embodiments the complete space for the cooling air is delimited by the heat dissipating structure. This embodiment has the advantage that, when the heat dissipating structure is made of a conducting material, the openings in this sidewall do not deteriorate the shielding properties of the electronic device. In many applications electronic devices have to meet predetermined electromagnetic compatibility (EMC) requirements. When openings are provided in the outer surfaces of the housing, electromagnetic radiation could exit or enter the housing through the openings for the air supply. However, if, according to the invention the openings are surrounded by the heat dissipating structures made of a conducting material, electromagnetic fields cannot exit the housing through the airflow guiding structure, as the airflow guiding structure is close to vis-à-vis the other internal compartments of the housing. As a consequence, the openings provided in the housing do not influence the electromagnetic compatibility of the electronic device.

As mentioned above the openings in the housing for the air supply may be provided in opposed side surfaces of the housing or in one of the side surfaces of the housing. According to one embodiment of the invention the openings for removing the cooling air from the housing can be provided in another surface of the housing where the supply openings are not provided, e. g. on a back surface of the housing. However, it should be understood that the opening for removing the cooling air could be provided at any surface of the housing, be it a front, an upper or a lower or a side surface.

According to the invention the heat dissipating structure is a substantially planar structure comprising recessed portions. Furthermore, as mentioned above the heat dissipating structure is preferably made of a heat and current conducting material. The recessed portions of the heat dissipating structure can then build the airflow guiding structure. This means that the cooling air is moving in the recessed portions of the heat dissipating structure. The recessed portions furthermore help to increase the surface of the heat dissipating structure increasing the heat dissipating capabilities of the heat dissipating structure. The larger the surface, the better the heat can be removed by the cooling air. According to one embodiment of the invention the first and the second heat dissipating structures are arranged relative to each other so that the recessed portions of both structures are opposing each other building the channels for the cooling air. In the non-recessed portions the two heat dissipating structures may contact each other. However, it is also possible that a small gap is provided between the two heat dissipating structures. In this embodiment both heat dissipating structures comprise the recessed portions building the airflow channel. However, it is also possible that only one heat dissipating structure comprises the recessed portions, the airflow guiding structure being built by the recess of one of the heat dissipating structures and of the other non-recessed part of the other heat dissipating structure. In a preferred embodiment, however, the two heat dissipating structures delimit the space in which the cooling air can move.

The housing of the electronic device can also be divided in a first part and into a second part, these two parts of the housing being separated by the airflow guiding structure. In this embodiment the first or upper heat dissipating structure can build a lower surface of the upper part of the housing, whereas the second or lower heat dissipating structure can build the upper surface of the lower part of the housing. These two parts of the housing are then separated by the space provided for the cooling air.

In order to effectively remove the heat it is possible to provide a ventilator or fan on a downstream side of the airflow guiding structure for removing the cooling air from the housing. The ventilator may be designed in such a way that it generates a lower pressure in the part of the heat dissipating structure in the housing and a high pressure outside the housing resulting in a movement of the cooling air from the airflow guiding structure to the outside of the housing. It is also possible to locate the ventilator on the upstream side of the airflow guiding structure, if the contact of the hot cooling air with the ventilator should be avoided. For an effective heat dissipation the heat dissipating structure has to be coupled to the heat generating unit in such a way that the transmission of heat from the heat generating unit to the heat dissipating structure is obtained. This can be obtained by either directly connecting the heat generating unit to the heat dissipating structure. However, according to a preferred embodiment of the present invention the heat generating unit is connected to the heat dissipating structure via a heat conducting pad. Such heat conducting pads may be made of silicon or any other heat conveying material. As mentioned above the cooling air is guided along the recessed portions of the heat dissipating structure. Thus, it is preferable to also connect the heat generating unit to the heat dissipating structure at the recessed portions of the latter. With such an arrangement the cooling efficiency can be further increased.

The airflow guiding structure may have any form allowing the cooling air to flow along the heat generating units. Preferably the recessed portions to which the heat generating units are connected are arranged in dependence on the position of the heat generating units within the housing. At a position of the heat generating unit the heat dissipating structure preferably builds a recess to which the heat generating unit is connected. It is possible to adapt the position of the recess to the location of the heat generating units or vice versa to adapt the location of the heat generating units to the location of the recessed portions.

In order to allow an airflow with low resistance, the supply channels through which the cooling air enters the housing can be inclined in such a way that the downstream end of the supply channels is closer to the outlet of the main airflow channel than the upstream end. Differently stated the cooling air in the supply channel may already comprise a component in the direction of the main airflow channel facilitating the movement of the cooling air from the supply channels to the main airflow channel.

The electronic device may be a stand-alone electronic device. However, it is also possible that the electronic device is adapted to be installed in a support structure mounted in a passenger compartment of a vehicle or at any other location inside the vehicle. In this case the opening or openings in the housing for supplying the cooling air and the opening or openings for removing the cooling air from the housing can be arranged in surfaces of the housing which are separated from the passenger compartment by the support structure. Thus, it can be avoided that air from the passenger compartment comprising dust particles such as smoke is used as cooling air.

### Brief Description of the Drawings

Specific embodiments of the invention will now be described by way of example with respect to the accompanying drawings, in which
Fig. 1 is a perspective side elevation view of an electronic device,
Fig. 2 is a perspective sectional rear view of the electronic device of Fig. 1,
Fig. 3 is a perspective sectional side view of the electronic device, and
Fig. 4 is a perspective rear view of the electronic device showing a lower heat dissipating structure.

### Detailed Description of the Preferred Embodiments

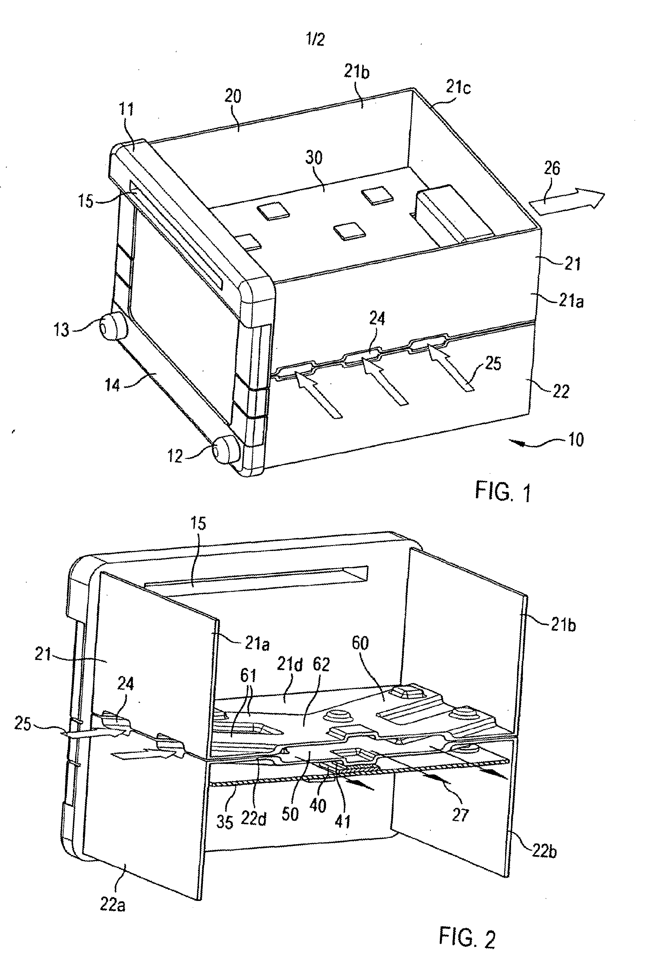

In Figs. 1 and 2 there is shown a perspective view of an electronic device 10. In the embodiment shown the electronic device is a built-in device which is normally installed in an accommodating structure or support structure (not shown) in a passenger compartment of a vehicle. The electronic device comprises a front surface designed as an operating unit 11 for controlling the functioning of the electronic device. The operating module 11 may comprise operating elements 12 and 13 and a display 14 displaying the operating status of the electronic device or displaying a menu structure needed for selecting different features of the electronic device. Furthermore, an insertion opening 15 may be provided allowing the insertion of a disk-like data carrier such as a compact disk or a DVD. It should be understood that the operating module 11 can be designed in a completely different way and that the other operating elements as the one shown in the figures could be used. When electronic device 10 is incorporated into a dashboard or a middle console of a vehicle, this operating module 11 is the part of the device visible to the passengers in the vehicle, whereas the other sides of the electronic device are not visible to the passengers in the passenger compartment. The electronic device 10 comprises a housing 20 which, in the present form, has a rectangular shape. However, any other shape could be used. In the embodiment shown the housing 20 comprises an upper part 21 and a lower part 22. The upper part 21 comprises side surfaces 21a and 21b and a rear surface 21c. On the lower end of the upper part 21 a lower surface 21d is provided. The lower part 22 comprises side surfaces 22a, 22b, a rear surface and an upper surface 22d facing the lower surface 21d of the upper part. The upper surface has been removed in order to allow the demonstration of further aspects important for the understanding of the invention. Inside the housing a first printed circuit board (PCB) 30 can be arranged in the housing, the PCB hosting several electronic components not shown in Fig. 1. These electronic components such as microprocessors or control units generate heat which has to be removed from the housing in order to keep the working temperature of the electronic device below a threshold value under which a proper functioning of the microprocessors can normally be guaranteed. For cooling these heat generating units ambient air has to be guided through the housing for removing the generated heat. To this end supply openings 24 and 25 are arranged in the side surfaces of the housing through which the cooling air enters the housing as shown by the arrows 25. The cooling air exits the housing at the rear surface 23 as shown by arrow 26.

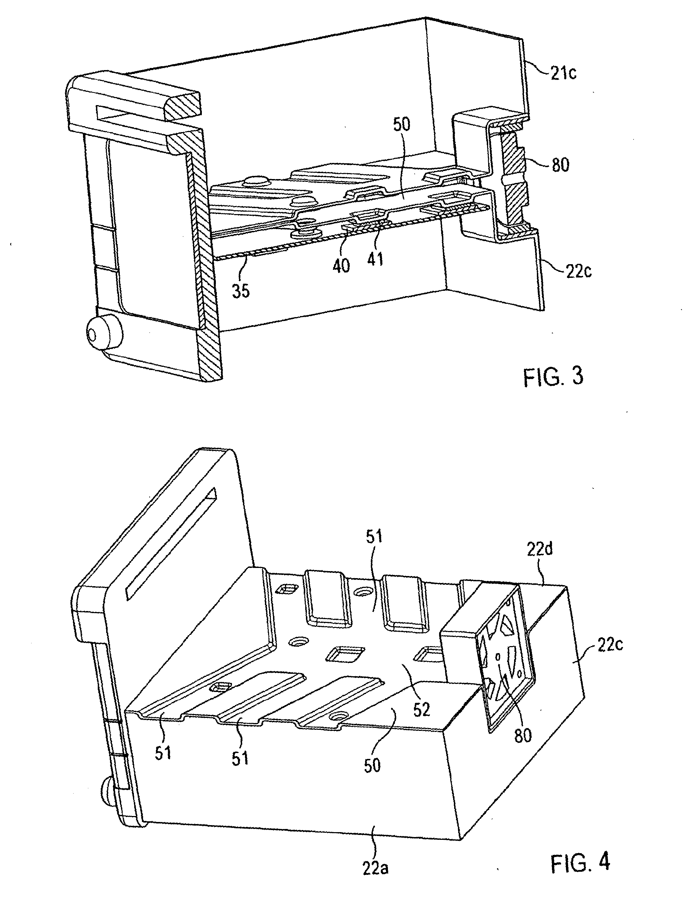

In Fig. 2 the structure for guiding the cooling air is shown in more detail. As can also be seen from Fig. 2 and 4 the sidewalls 21a, b and 22a, b, are designed in a two-part form. As shown in Fig. 2 the sidewall comprises an upper part 21a and a lower part 22a. In the embodiment shown in Fig. 2 the upper printed circuit board 30 shown in Fig. 1 is removed for the sake of clarity. In Fig. 2, however, a lower circuit board 35 is shown. The circuit board 35 comprises microprocessors or heat generating units 40 connected to the circuit board 35. On the upper surface of the heat generating unit 40 a heat conducting pad 41 is provided. This heat conducting pad is made of a material having a high thermal conductivity so that the heat generated by the unit 40 can be dissipated through the pad 41. This pad itself is then connected to a lower or second heat dissipating structure 50. This lower second heat dissipating structure 50 is also shown in Fig. 4. A second heat dissipating structure builds, together with a first heat dissipating structure 60, an airflow guiding structure. The first and a second heat dissipating structures comprise recessed areas which build the space for the airflow of cooling air. In Fig. 2 recessed areas 61 and 62 are shown in the first heat dissipating structure. The cooling air entering the housing through opening 24 is guided through supply channels formed by the recessed areas or portions 61 of the upper heat dissipating structure and by recessed areas 51 of the lower heat dissipating structure 50. The cooling air then enters a main airflow channel delimited by the recessed portion 62 shown in Fig. 2 and the recessed portion 52 shown in Fig. 4.

The heat dissipating structures 50 and 60 of the surfaces 21d and 22d delimit the space through which the cooling air can move through the housing. The heat dissipating structure has a double function. It helps to dissipate the heat generated by the heat generating unit, and it helps to provide an airflow guiding structure guiding the movement of the cooling air.

In the embodiment shown the recessed portions 51 and 61 form the supply channels, whereas the recessed portions in the middle 52, 62 form the main airflow channel. As shown in Fig. 2 heat generating units 40 can be connected to the main airflow channel and to the supply channels. By connecting the heat generating unit to the recessed portions, the highest temperatures are obtained in portions of the heat dissipating structure which are cooled by the cooling air. The arrows 25 and 27 shown in Fig. 2 indicate the direction of the airflow in the main channel after the cooling air has left the supply channels. It should be understood that any other geometrical form of the airflow guiding structure can be used. Preferably the form of the airflow guiding structure guiding the cooling air through the housing is adapted depending on the position of the heat generating units in the housing.

In order to effectively remove the cooling air from the housing after the latter has passed through the housing a ventilator 80 may be provided at the downstream end of the airflow guiding structure as shown in Fig. 4. In the embodiment shown the downstream end is the downstream end of the main airflow channel. It should be understood that it is also possible to provide a ventilator in an airflow guiding structure at the air inlet providing cooling air to the housing. It is also possible to guide the air through the housing in the reverse direction, i.e. the air enters the housing at the rear end at the ventilator 80 and exits the housing at the openings 24 provided in the side surfaces. This arrangement may be necessary when the removed cooling air has a temperature above a critical temperature above which the ventilator 80 cannot function properly any more. Here the cooling air enters the housing at the openings at which the ventilator is provided, so that the entering cooling air does not damage the ventilator. The hot air is then removed at the end where no ventilator is provided.

As can be seen in Figs. 2 and 4, the housing itself can be divided into two parts. In Fig. 4 a lower part 22 of the housing is shown. The lower part of the housing is built by the lower side surfaces 22a and 22b, by a lower rear surface 22c and by the upper surface 22d working as lower heat dissipating structure 50. All these outer surfaces are made of a conducting material so that electromagnetic fields cannot penetrate or exit the inner part of the lower housing. The upper part of the housing is built by the upper parts of the side surfaces 21a and 21b shown in Fig. 2, an upper back surface 21c, a top surface (not shown) and by the lower surface 21d working as upper heat dissipating structure 60. The housing is divided into two parts, an upper part and a lower part. These two parts of the housing are separated by the airflow guiding structure built by the two heat dissipating structures 50 and 60. In each part of the housing heat generating units can be provided which can be cooled by the airflow between the two parts of the housing.

The above-described example shows that this invention provides an effective way for cooling an electronic device having several heat generating units provided in a housing. The invention allows to effectively dissipate the heat and additionally allows an effective guiding of the cooling air along a surface of the heat dissipating structure. A further advantage of the invention can be seen in the fact that the openings provided in the surfaces of the housing do not deteriorate the electromagnetic compatibility, as electromagnetic fields cannot enter or exit the housing through the openings. In the embodiment shown the mechanical stability is also improved due to the two heat dissipating structures extending substantially along the complete width of the housing. Furthermore, the electronic device of the invention has the advantage that the circulation of cooling air in areas where the existence of such a cooling air could deteriorate the functioning of the electronic is avoided. By way of example, as can be seen, a data carrier can be inserted through the opening 15 provided in the upper part of the operating module. Accordingly, in this upper part of the housing a data carrier reading module is provided (not shown). As can be seen form the figures, the cooling air does not circulate in the part of the housing where this reading module is provided, as the cooling air is limited to the space between the two heat dissipating structures. Furthermore, the cooling air does not circulate around other electronic modules provided on the printed circuit boards.

## Claims

1. Electronic device comprising:
- at least one first heat generating unit (40),
- a housing (20) in which said at least one first heat generating unit (40) is installed,
- an airflow guiding structure adapted to guide cooling air through the housing (20) for cooling said heat generating unit,
- a first heat dissipating structure (50) coupled to said at least one first heat generating unit (40) for dissipating the generated heat, said first heat dissipating structure (50) building a first side wall of the airflow guiding structure,
wherein the airflow guiding structure is at least partly built by said first heat dissipating structure (50, 60) **characterized by** further comprising a second side wall building the airflow guiding structure together with the first side wall, wherein the heat dissipating structure (50, 60) is a substantially planar structures comprising recessed portions (51, 52, 61, 62), the recessed portions (51, 52, 61, 62) building the airflow guiding structure.

2. Electronic device according to claim 1, wherein the second side wall is built by a second heat dissipating structure (60) coupled to at least one second heat generating unit.

3. Electronic device according to claim 2, wherein the airflow guiding structure is built by the first and by the second heat dissipating structure (50, 60).

4. Electronic device according to any of the preceding claims, wherein the airflow guiding structure comprises a main airflow channel and supply channels discharging into the main airflow channel.

5. Electronic device according to any of the preceding claims, wherein the housing (20) comprises openings (24, 25) through which the cooling air is supplied to the airflow guiding structure.

6. Electronic device according to claim 5, wherein the openings (24, 25) are provided in different side surfaces (21, 22) of the housing, the supplied air being guided through the supply channels to the main airflow channel.

7. Electronic device according to any of claims 4 to 6, wherein the main airflow channel opens in another surface (23) of the housing.

8. Electronic device according to any of claims 2 to 7, wherein the first and the second heat dissipating structures (50, 60) are arranged relative to each other in such a way that the recessed portions (51, 52, 61, 62) of both structures are opposing each other building the airflow guiding structure.

9. Electronic device according to any of claims 5 to 8, wherein the inlet openings (24, 25) for the supplied air are arranged in opposite side surfaces (21, 22) of the housing.

10. Electronic device according to any of the preceding claims, wherein a ventilator (80) is provided on the downstream side of the airflow guiding structure for removing the cooling air from the housing (20).

11. Electronic device according to any of the preceding claims, wherein the heat generating units (40) are coupled to the heat dissipating structure at the recessed portions (51, 52, 61, 62) thereof.

12. Electronic device according to any of the preceding claims, wherein the heat generating unit (40) is coupled to the heat dissipating structure via a heat conducting pad (41).

13. Electronic device according to any of claims 4 to 12, wherein the supply channels are inclined towards the outlet of the main airflow channel.

14. Electronic device according to any of the preceding claims, wherein the housing comprises a first part and a second part, the airflow guiding structure separating the first part of the housing from the second part of the housing.

15. Electronic device according to any of the preceding claims, wherein the electronic device is a built in structure adapted to be installed in a support structure mounted in a vehicle.

16. Electronic device according to claim 15, wherein the opening in the housing for supplying the cooling air and the opening for removing the cooling air from the housing are arranged in surfaces of the housing which are separated from the passenger compartment by the support structure, when the electronic device is installed in the support structure.

17. Electronic device according to any of the preceding claims, wherein the first and the second heat dissipating structures extend substantially along the complete width of the housing.

## Patentansprüche

1. Elektronische Vorrichtung, umfassend:
- mindestens eine erste Hitze erzeugende Einheit (40),
- ein Gehäuse (20), in welchem die mindestens eine erste Hitze erzeugende Einheit (40) installiert ist,
- eine Luftstrom-Führungsstruktur, welche ausgestaltet ist, Kühlungsluft durch das Gehäuse (20) zum Kühlen der Hitze erzeugenden Einheit zu führen,
- eine erste Hitze dissipierende Struktur (50), die an die mindestens eine erste Hitze erzeugende Einheit (40) zum Dissipieren der erzeugten Hitze gekoppelt ist, wobei die erste Hitze dissipierende Struktur (50) eine erste Seitenwand der Luftstrom-Führungsstruktur ausbildet,
wobei die Luftstrom-Führungsstruktur zumindest teilweise durch die erste Hitze dissipierende Struktur (50, 60) ausgebildet ist, **dadurch** charakterisiert, dass sie weiterhin eine zweite Seitenwand umfasst, welche die Luftstrom-Führungsstruktur zusammen mit der ersten Seitenwand ausbildet, wobei die Hitze dissipierende Struktur (50, 60) eine im Wesentlichen ebene Struktur ist, welche zurückgesetzte Abschnitte (51, 52, 61, 62) umfasst, wobei die zurückgesetzten Abschnitte (51, 52, 61, 62) die Luftstrom-Führungsstruktur ausbilden.

2. Elektronische Vorrichtung nach Anspruch 1, wobei die zweite Seitenwand durch eine zweite Hitze dissipierende Struktur (60) ausgebildet ist, die an mindestens eine zweite Hitze erzeugende Einheit gekoppelt ist.

3. Elektronische Vorrichtung nach Anspruch 2, wobei die Luftstrom-Führungsstruktur durch die erste und durch die zweite Hitze dissipierende Struktur (50, 60) ausgebildet ist.

4. Elektronische Vorrichtung nach einem der voranstehenden Ansprüche, wobei die Luftstrom-Führungsstruktur einen Hauptluftstrom-Kanal und Versorgungskanäle, die in den Hauptluftstrom-Kanal ableiten, umfasst.

5. Elektronische Vorrichtung nach einem der voranstehenden Ansprüche, wobei das Gehäuse (20) Öffnungen (24, 25) umfasst, durch welche die Kühlungsluft der Luftstrom-Führungsstruktur bereitgestellt wird.

6. Elektronische Vorrichtung nach Anspruch 5, wobei die Öffnungen (24, 25) auf verschiedenen Seitenoberflächen (21, 22) des Gehäuses bereitgestellt sind, wobei die bereitgestellte Luft durch die Versorgungskanäle zu dem Hauptluftstrom-Kanal geführt wird.

7. Elektronische Vorrichtung nach einem der Ansprüche 4 bis 6, wobei der Hauptluftstrom-Kanal eine weitere Oberfläche (23) des Gehäuses öffnet.

8. Elektronische Vorrichtung nach einem der Ansprüche 2 bis 7, wobei die erste und die zweite Hitze dissipierende Struktur (50, 60) relativ zueinander derart angeordnet sind, dass die zurückgesetzten Abschnitte (51, 52, 61, 62) beider Strukturen einander gegenüber liegen und derart die Luftstrom-Führungsstruktur ausbilden.

9. Elektronische Vorrichtung nach einem der Ansprüche 5 bis 8, wobei die Einlassöffnungen (24, 25) für die bereitgestellte Luft auf gegenüberliegenden Seitenoberflächen (21, 22) des Gehäuses angeordnet sind.

10. Elektronische Vorrichtung nach einem der voranstehenden Ansprüche, wobei ein Ventilator (80) auf der stromabwärts liegenden Seite der Luftstrom-Führungsstruktur zum Entfernen der Kühlungsluft aus dem Gehäuse (20) bereitgestellt ist.

11. Elektronische Vorrichtung nach einem der voranstehenden Ansprüche, wobei die Hitze erzeugenden Einheiten (40) an die Hitze dissipierendene Struktur an deren zurückgesetzten Abschnitten (51, 52, 61, 62) gekoppelt sind.

12. Elektronische Vorrichtung nach einem der voranstehenden Ansprüche, wobei die Hitze erzeugende Einheit (40) mittels eines Hitze leitenden Kissens (41) an die Hitze dissipierende Struktur gekoppelt ist.

13. Elektronische Vorrichtung nach einem der Ansprüche 4 bis 12, wobei die Versorgungskanäle hin zu dem Auslass des Hauptluftstrom-Kanals geneigt sind.

14. Elektronische Vorrichtung nach einem der voranstehenden Ansprüche, wobei das Gehäuse einen ersten Teil und einen zweiten Teil umfasst, wobei die Luftstrom-Führungsstruktur den ersten Teil des Gehäuses von dem zweiten Teil des Gehäuses trennt.

15. Elektronische Vorrichtung nach einem der voranstehenden Ansprüche, wobei die elektronische Vorrichtung eine Einbaustruktur ist, welche ausgestaltet ist, in einer Stützstruktur, die in einem Fahrzeug befestigt ist, installiert zu werden.

16. Elektronische Vorrichtung nach Anspruch 15, wobei die Öffnung in dem Gehäuse zum Bereitstellen der Kühlungsluft und die Öffnung zum Entfernen der Kühlungsluft aus dem Gehäuse auf Oberflächen des Gehäuses angeordnet sind, die von dem Passagierabteil mittels der Stützstruktur getrennt sind, wenn die elektronische Vorrichtung in der Stützstruktur installiert ist.

17. Elektronische Vorrichtung nach einem der voranstehenden Ansprüche, wobei die erste und die zweite Hitze dissipierende Struktur sich im Wesentlichen entlang der gesamten Breite des Gehäuses erstreckt.

## Revendications

1. Dispositif électronique, comportant:
- au moins une première unité de production de chaleur (40),
- un boîtier (20), dans lequel est installée ladite au moins une première unité de production de chaleur (40),
- un structure de guidage de flux d'air adaptée à guider de l'air de refroidissement à travers le boîtier (20) pour refroidir ladite unité de production de chaleur,
- une première structure de dissipation de la chaleur (50) couplée à ladite au moins une première unité de production de chaleur (40) pour dissiper la chaleur produite, ladite première structure de dissipation de la chaleur (50) constituant une première paroi latérale de la structure de guidage de flux d'air,
dans lequel la structure de guidage de flux d'air est au moins partiellement constituée de ladite première structure de dissipation de la chaleur (50, 60), **caractérisé en ce qu'**il comporte en outre une deuxième paroi latérale constituant la structure de guidage de flux d'air conjointement avec la première paroi latérale, dans lequel la structure de dissipation de la chaleur (50, 60) est une structure essentiellement planaire comportant des portions en retrait (51, 52, 61, 62), les portions en retrait (51, 52, 61, 62) constituant la structure de guidage de flux d'air.

2. Dispositif électronique selon la revendication 1, dans lequel la deuxième paroi latérale est constituée d'une deuxième structure de dissipation de la chaleur (60) couplée à au moins une deuxième unité de production de chaleur.

3. Dispositif électronique selon la revendication 2, dans lequel la structure de guidage de flux d'air est constituée par les première et la deuxième structures de dissipation de la chaleur (50, 60).

4. Dispositif électronique selon l'une quelconque des revendications précédentes, dans lequel la structure de guidage de flux d'air comporte un conduit principal de flux d'air et des conduits d'alimentation débouchant dans le conduit principal de flux d'air.

5. Dispositif électronique selon l'une quelconque des revendications précédentes, dans lequel le boîtier (20) comporte des orifices (24, 25) à travers lesquels l'air de refroidissement est fourni à la structure de guidage de flux d'air.

6. Dispositif électronique selon la revendication 5, dans lequel les orifices (24, 25) sont prévus dans des surfaces latérales différentes (21, 22) du boîtier, l'air fourni étant guidé à travers les conduits d'alimentation vers le conduit principal de flux d'air.

7. Dispositif électronique selon l'une quelconque des revendications 4 à 6, dans lequel le conduit principal de flux d'air débouche dans une autre surface (23) du boîtier.

8. Dispositif électronique selon l'une quelconque des revendications 2 à 7, dans lequel les première et deuxième structures de dissipation de la chaleur (50, 60) sont arrangées l'une par rapport à l'autre de telle manière que les portions en retrait (51, 52, 61, 62) des deux structures sont disposées en vis-à-vis, constituant ainsi la structure de guidage de flux d'air.

9. Dispositif électronique selon l'une quelconque des revendications 5 à 8, dans lequel les orifices d'admission (24, 25) pour l'air fourni sont arrangés dans des surfaces latérales opposées (21, 22) du boîtier.

10. Dispositif électronique selon l'une quelconque des revendications précédentes, dans lequel un ventilateur (80) est prévu du côté aval de la structure de guidage de flux d'air pour évacuer l'air de refroidissement du boîtier (20).

11. Dispositif électronique selon l'une quelconque des revendications précédentes, dans lequel les unités de production de chaleur (40) sont couplées à la structure de dissipation de la chaleur dans les portions en retrait (51, 52, 61, 62) de celle-ci.

12. Dispositif électronique selon l'une quelconque des revendications précédentes, dans lequel l'unité de production de chaleur (40) est couplée à la structure de dissipation de la chaleur par l'intermédiaire d'un tampon thermoconducteur (41).

13. Dispositif électronique selon l'une quelconque des revendications 4 à 12, dans lequel les conduits d'alimentation sont inclinés vers la sortie du conduit principal de flux d'air.

14. Dispositif électronique selon l'une quelconque des revendications précédentes, dans lequel le boîtier comporte une première partie et une deuxième partie, la structure de guidage de flux d'air séparant la première partie du boîtier de la deuxième partie du boîtier.

15. Dispositif électronique selon l'une quelconque des revendications précédentes, dans lequel le dispositif électronique est une structure incorporée adaptée à être installée dans une structure de support montée dans un véhicule.

16. Dispositif électronique selon la revendication 15, dans lequel l'orifice d'alimentation de l'air de refroidissement dans le boîtier et l'orifice d'évacuation de l'air de refroidissement du boîtier sont arrangés dans des surfaces du boîtier qui sont séparées de l'habitacle par la structure de support, lorsque le dispositif électronique est installé dans la structure de support.

17. Dispositif électronique selon l'une quelconque des revendications précédentes, dans lequel les première et deuxième structures de dissipation de chaleur s'étendent essentiellement le long de la largeur totale du boîtier.
